# EUROPEAN PATENT SPECIFICATION

(11) **EP 0 400 560 B1**
(45) Date of publication and mention of the grant of the patent: **11.08.1993**
(21) Application number: 90110128.7
(22) Date of filing: 29.05.1990
(51) Int. Cl.: C04B 35/80

(54) **Method of producing high density fiber reinforced composite material**
Verfahren zur Herstellung eines faserverstärkten Verbundstoffes von hoher Dichte
Procédé de fabrication d'un matériau composite à haute densité renforcé par des fibres

(30) Priority: 31.05.1989 JP 139846/89
(43) Date of publication of application: 05.12.1990
(73) Proprietor: SUMITOMO ELECTRIC INDUSTRIES, LTD., Osaka-shi, Osaka 541 (JP)
(72) Inventor: Sakagami, Seigou, c/o Itami Works of Sumitomo, Itami-shi, Hyogo (JP); Kawase, Makoto, c/o Itami Works of Sumitomo, Itami-shi, Hyogo (JP); Wakamatsu, Satoshi, c/o Itami Works of Sumitomo, Itami-shi, Hyogo (JP); Iwata, Kouichi, c/o Osaka Works of Sumitomo, Konohana-ku, Osaka (JP); Adschiri, Tadafumi, Sendai-shi, Miyagi-ken (JP)
(74) Representative: Herrmann-Trentepohl, Werner, Dipl.-Ing.

(56) References cited:
- EP-A- 0 188 270

## Description

The present invention relates to a method of producing a high density fiber reinforced composite material, and more particularly, it relates to a method of producing a fiber reinforced composite material of high density by performing chemical deposition on a porous fiber reinforced composite material and lowering its porosity.

In general, a fiber reinforced composite material having high porosity, such as a carbon fiber reinforced carbon composite material, for example, has been reduced in porosity by a method such as resin (pitch) impregnation, CVD (chemical vapor deposition), pressure impregnation carbonization or the like, as described in "Tanso Senni Sangyo" by Kennichi Morita, Kindai Henshu-sha, pp. 176 -- 178. As to formation of a matrix in a liquid phase by the method such as resin (pitch) impregnation, however, infiltration of the liquid into a base material for the composite material is limited such that the interior of the base material may remain in high porosity because of difficulty in infiltration of the liquid, although porosity of a part around its surface layer can be lowered by impregnation of the liquid. While it may be considered to use a liquid of low viscosity for impregnation into the interior of the base material, such a liquid of low viscosity is so inferior in yield upon carbonization that the base material entirely remains in high porosity.

In relation to a fiber reinforced composite material having a matrix of carbon or ceramics such as SiC, Si₃N₄, SiO₂, TiC, Al₂O₃, B₄C, TiN, BN or the like, CVI (chemical vapor infiltration) is known as a method which has recently been watched with interest (refer to Am. Ceram. Soc. Bull., 65 [2] 347-50 (1986)).

Also in such chemical vapor deposition (CVD/CVI) of generating a matrix from a vapor phase, however, matrix deposition on an outermost surface layer generally takes place at a speed higher than the rate of gas diffusion to block pores of a porous fiber reinforced composite material, which is the target of deposition, and prevent infiltration of the vapor phase into the interior of the material. Further, a pyrolytic product in the vapor phase such as pyrolytic carbon is not only deposited on the surface of the base material (fiber reinforced composite material) but also generated as soot in the vapor phase, to be adhered onto the base material (fiber reinforced composite material) and promote blocking of the pores.

On the other hand, deposition conditions are changed if the pores are changed in diameter. In order to reduce the processing time, therefore, it is necessary to perform chemical deposition while adjusting/increasing the rate of deposition to the maximum within an allowable range in response to the change of the pore diameters. In practice, however, it is impossible to calculate the upper limit of the rate of deposition which is allowed in response to the change of the pore diameters due to various factors. Thus, vapor deposition has generally been performed while adjusting the rate of deposition to be sufficiently small with respect to the rate of gas diffusion in response to extremely small pore diameters. Under this condition, the processing time is disadvantageously increased due to the slow rate of deposition. Even in this case, excessive deposition to the surface of the base material (fiber reinforced composite material), particularly deposition of soot, is unavoidably caused such that an excess step is inevitably required to intermittently scrape off the surface deposition layer in order to grow a deposition layer in the matrix up to the interior of the fiber reinforced composite material, while the pores are preferentially narrowed even if such an excess step is carried out. Thus, it is difficult to densify the material up to its interior.

In consideration of the aforementioned circumstances, an object of the present invention is to provide a method of producing a high density fiber reinforced composite material, which can quickly and homogeneously lower porosity of a porous fiber reinforced composite material up to its interior without intermittently scraping off a surface deposition layer.

The invention defined in claim 1 is directed to a method of producing a high density fiber reinforced composite material by performing chemical vapor deposition of depositing a product by a vapor mixture of vapor of reactive molecules and particles of an inert carrier on a porous fiber reinforced composite material for lowering its porosity by deposition/adhesion of the product in the interior of the fiber reinforced composite material. The chemical deposition process is performed by locating the fiber reinforced composite material, which is the target of deposition, in a fluidized bed for fluidization of the carrier.

The invention defined in claim 2 is characterized in that, in the invention defined in claim 1, one or at least two of whiskers, staple, paper, felt, lint, nonwoven fabric, two dimensional woven fabric and nD material (n ≧ 3) are contained in reinforcing fiber for the fiber reinforced composite material.

The invention defined in claim 3 is characterized in that, in the invention defined in claim 1, one or at least two of fiber materials or whiskers of ceramics such as SiC, Si₃N₄ and B, and carbon are contained in reinforcing fiber for the fiber reinforced composite material.

The invention defined in claim 4 is characterized in that, in the invention defined in any of claims 1 to 3, one or at least two of ceramic materials such as SiC, Si₃N₄, SiO₂, TiC, Al₂O₃, B₄C, TiN and BN, and carbon are contained in a matrix of the fiber reinforced composite material.

In the invention defined in claim 1, chemical deposition is performed in a fluidized bed for fluidization of a prescribed carrier employed for the chemical deposition, whereby generation of a pyrolytic product in the vapor phase is suppressed and the rate of deposition on the surface layer of the fiber reinforced composite material is reduced by the function of the fluidized bed while pores of the fiber reinforced composite material are not blinded and the diameters thereof are hardly changed since the carrier flowing in the fluidized bed itself is regularly in a moving state. Consequently, the fiber reinforced composite material can be processed under a condition of increasing the rate of deposition, and can be densified up to its interior. Even if a core of a pyrolytic product is generated in the vapor phase, the same is immediately adhered to the carrier flowing in the fluidized bed and not largely grown to reach the surface of the fiber reinforced composite material. Even if such a pyrolytic product is deposited on/adhered to the surface of the fiber reinforced material, the same is struck and scraped off by the carrier flowing in the fluidized bed since adhesion strength thereof is relatively small. Due to the function of the carrier flowing in the fluidized bed for transferring heat, the temperature of the fiber reinforced composite material is brought into a uniform and homogeneous state with no temperature gradient. Thus, it is possible to uniformly fill up communicating holes without covering up the same, by comprehending relation between change in pore structure of the fiber reinforced composite material and the reaction rate.

In the invention defined in claim 2, one or at least two of whiskers, staple, paper, felt, lint, nonwoven fabric, two dimensional woven fabric and nD material (n ≧ 3) are contained in reinforcing fiber for the fiber reinforced composite material according to the invention defined in claim 1, to satisfactorily fulfill the function of the reinforcing fiber for the fiber reinforced composite material.

In the invention defined in claim 3, one or at least two of fiber materials or whiskers of ceramics such as SiC, Si₃N₄ and B, and carbon are contained in reinforcing fiber for the fiber reinforced composite material according to the invention defined in claim 1, to satisfactorily fulfill the function of the reinforcing fiber for the fiber reinforced composite material.

In the invention defined in claim 4, one or at least two of ceramic materials such as SiC, Si₃N₄, SiO₂, TiC, Al₂O₃, B₄C, TiN and BN, and carbon are contained in a matrix of the fiber reinforced composite material according to the invention defined in any of claims 1 to 3, to satisfactorily fulfill the function of the matrix for the fiber reinforced composite material.

The invention defined in claim 1 is adapted to suppress generation of a pyrolytic product in the vapor phase and reduce the rate of deposition onto the surface of the fiber reinforced composite material by performing chemical deposition in the fluidized bed. Thus, an excess step of scraping off the surface deposition layer of the fiber reinforced composite material etc. can be omitted to quickly obtain a high density fiber reinforced composite material which is dense up to its interior.

The invention defined in claim 2 or 3 can satisfactorily fulfill the function of the reinforcing fiber for the fiber reinforced composite material, in addition to the effect of the invention defined in claim 1.

The invention defined in claim 4 can satisfactorily fulfill the function of the matrix for the fiber reinforced composite material, in addition to the effect of the invention defined in any of claims 1 to 3.

Examples of the present invention are now described.

### Example 1

(1) A fluidized heating medium (quartz sand) serving as a carrier and a C/C composite (10 x 10 mm, porosity: 40 %) were introduced into a reaction pipe.
(2) A vapor mixture of propylene and nitrogen was introduced from a lower part of the reaction pipe, to perform chemical deposition (CVI) at 800°C for 10 hours.
(3) The sample was extracted for measurement of porosity, which was 15 %.

### Comparative Example 1

A sample for reference was prepared in a similar manner to Example 1, to perform chemical deposition (CVI) using no fluidized heating medium. The surface of this sample was covered with a pyrolytic product (soot), and substantially no carbon matrix was formed in its interior.

### Example 2

(1) A fluidized heating medium (quartz sand) serving as a carrier and three dimensional woven carbon fiber (10 x 10 mm, porosity: 60 %) were introduced into a reaction pipe.
(2) A vapor mixture of silicon tetrachloride, methane and nitrogen was introduced from a lower part of this reaction pipe, to perform chemical deposition (CVI) at 500°C for 20 hours.
(3) The sample was converted to carbon fiber reinforced silicon carbide, whose porosity was 20 %.

### Comparative Example 2

A sample for reference was prepared in a similar manner to Example 2, to perform chemical deposition (CVI) for two hours using no fluidized heating medium. The surface of this sample was covered with soot, and substantially no silicon carbide was formed therein.

Although the C/C composite and the three dimensional woven carbon fiber are employed as exemplary porous fiber reinforced composite materials in the above Examples, the present invention is not restricted to the same. A fiber material containing one or at least two of whiskers, staple, paper, felt, lint, nonwoven fabric, two dimensional woven fabric and nD material (n ≧ 3) is employed as reinforcing fiber for the porous fiber reinforced composite material. Alternatively, the reinforcing fiber may be prepared from a material containing one or at least two of fiber materials or whiskers of ceramics such as SiC, Si₃N₄ and B, and carbon. Further, the matrix of the fiber reinforced composite material is prepared from a material containing one or at least two of ceramics such as SiC, Si₃N₄, SiO₂, TiC, Al₂O₃, B₄C, TiN and BN, and carbon.

## Claims

1. A method of producing a fibre reinforced composite material of high density wherein:
- chemical vapour deposition is performed on a porous fibre reinforced composite material for lowering its porosity and for densifying said material up to its interior,
- the chemical vapour deposition process is performed by locating the fibre reinforced material, which is the target of deposition, in a fluidized bed of particles of a carrier, which is inert with respect to said composite material, together with a reactive vapour mixture,
- the reaction product of said reactive vapour mixture is deposited/adhered in the interior of said fibre reinforced composite material.

2. A method of producing a high density fiber reinforced composite material in accordance with claim 1, wherein reinforcing fiber for said fiber reinforced composite material contains one or at least two of whiskers, staple, paper, felt, lint, nonwoven fabric, two dimensional woven fabric and nD material (n ≧ 3).

3. A method of producing a high density fiber reinforced composite material in accordance with claim 1, wherein reinforcing fiber for said fiber reinforced composite material contains one or at least two of fiber materials or whiskers of ceramics such as SiC, Si₃N₄ and B, and carbon.

4. A method of producing a high density fiber reinforced composite material in accordance with claim 1, wherein a matrix of said fiber reinforced composite material contains one or at least two of ceramic materials such as SiC, Si₃N₄, SiO₂, TiC, Al₂O₃, B₄C, TiN and BN, and carbon.

## Patentansprüche

1. Verfahren zur Herstellung eines faserverstärkten Verbundstoffe von hoher Dichte, wobei:
- eine chemische Dampfabscheidung auf einem porösen faserverstärkten Verbundstoff zur Verringerung seiner Porosität zur Verdichtung des Materials bis in sein Inneres durchgeführt wird,
- der chemische Dampfabscheidungsprozeß durch die Anordnung des faserverstärkten Materials, das das Target der Abscheidung darstellt, zusammen mit einer reaktiven Dampfmischung in einem Wirbelbett aus Teilchen eines Trägers durchgeführt wird, der in Bezug auf den Verbundstoff inert ist, und
- das Reaktionsprodukt der reaktiven Dampfmischung im Inneren des faserverstärkten Vebundstoffs abgeschieden wird bzw. an diesem anhaftet.

2. Verfahren zur Herstellung eines faserverstärkten Verbundstoffe von hoher Dichte gemäß Anspruch 1, wobei die verstärkende Faser für den faserverstärkten Verbundstoff ein oder mindestens zwei der Materialien Whiskerkristalle, Fasern, Papier, Filz, Lintbaumwolle, ungewebte Textilmaterialien, 2 D dimensional gewebte Textilmaterialien und nD Materialien (n ≧ 3) enthält.

3. Verfahren zur Herstellung eines faserverstärkten Verbundstoffe von hoher Dichte gemäß Anspruch 1, wobei die verstärkende Faser für den faserverstärkten Verbundstoff ein oder mindestens zwei der Fasermaterialien oder Whiskerkristalle aus Keramiken wie SiC, Si₃N₄ und B sowie Kohlenstoff enthält

4. Verfahren zur Herstellung eines faserverstärkten Verbundstoffs von hoher Dichte gemäß Anspruch 1, wobei eine Matrix des faserverstärkten Verbundstoffs ein oder mindestens zwei der Keramikmaterialien wie SiC, Si₃N₄, Tic, Al₂O₃, B₄C, TiN und BN sowie Kohlenstoff enthält.

## Revendications

1. Procédé de production d'un matériau composite à haute densité renforcé par fibres, dans lequel :
un dépôt chimique en phase vapeur est effectué sur un matériau composite poreux renforcé par fibres pour réduire sa porosité et pour densifier ledit matériau à l'intérieur ;
le processus de dépôt chimique en phase vapeur est effectué en plaçant le matériau renforcé par fibres, qui est une cible de dépôt, dans un lit fluidisé de particules d'un support, qui est inerte par rapport audit matériau composite, en même temps qu'un mélange de réaction en phase vapeur ;
le produit de la réaction dudit mélange de réaction en phase vapeur est déposé/rendu adhérent à l'intérieur dudit matériau composite renforcé par fibres.

2. Procédé de production d'un matériau composite à haute densité renforcé par fibres, selon la revendication 1, dans lequel la fibre de renforcement pour ledit matériau composite renforcé par fibres contient un, ou au moins deux, des produits suivants : barbes, soie de coton, papier, feutre, coton égrainé, étoffe non tissée, tissu bidimensionnel et matière nD (n ≧ 3).

3. Procédé de production d'un matériau composite à haute densité renforcé par fibres, selon la revendication 1, dans lequel la fibre de renforcement pour ledit matériau composite renforcé par fibres contient un, ou au moins deux, des produits suivants : matières fibreuses ou barbes de céramique comme SiC, Sl₃N₄, et B, et du carbone.

4. Procédé de production d'un matériau composite à haute densité renforcé par fibres, selon la revendication 1, dans lequel la fibre de renforcement pour ledit matériau composite renforcé par fibres contient un, ou au moins deux, produits à base de céramique tels que SiC, Si₃N₄, SiO₂, TiC, Al₂O₃, B₄C, TiN et BN, et du carbone.
